# DEMANDE DE BREVET EUROPEEN

(11) **EP 2 184 860 A1**
(43) Date de publication de la demande: **12.05.2010**
(21) Numéro de dépôt: 09172694.3
(22) Date de dépôt: 09.10.2009
(51) Int. Cl.: H04B 1/08

(54) **Appareil électronique audio/vidéo, notamment autoradio, à façade amovible**

(30) Priorité: 06.11.2008 FR 0806198
(71) Demandeur: Parrot, 75010 Paris (FR)
(72) Inventeur: Fargeau, Karim, 94220 Charenton Le Pont (FR); Tea, David, 77185 Lognes (FR); Vignau-Lous, Bertrand, 75018 Paris (FR)
(74) Mandataire: Dupuis-Latour, Dominique

(57) **Abrégé**

L'appareil comporte un boîtier (100), une façade amovible (200), un connecteur électrique (108, 208) et des moyens mécaniques d'assemblage et de fixation de la façade sur le boîtier. Ces derniers comprennent à une première extrémité des moyens formant charnière démontable comportant au moins une paire d'éléments magnétiques respectifs (132, 232 ; 134, 234) tels que des aimants permanents disposés dans la région du connecteur en vis-à-vis sur le boîtier et sur la façade, et à l'extrémité opposée des moyens (112, 212) de verrouillage de la façade au boîtier. Le couplage mécanique de la façade et du boîtier à l'endroit de la charnière magnétique démontable ne résulte que de l'attraction mutuelle des éléments magnétiques en vis-à-vis.

## Description

L'invention concerne les appareils électroniques audio/vidéo comportant un boîtier muni d'un élément, tel qu'une façade, monté de manière amovible sur le boîtier.

Elle s'applique plus particulièrement aux autoradios, dont le boîtier est intégré à demeure dans le tableau de bord du véhicule automobile, avec une façade antivol amovible portant notamment divers boutons de commande, afficheurs, etc. La façade peut également permettre de découvrir une fente d'insertion d'un disque compact.

Toutefois, l'application aux autoradios, si elle est particulièrement avantageuse, n'est pas limitative de l'invention qui, comme on le comprendra, peut être appliquée à de très nombreux types d'autres appareils électroniques.

Un autoradio comportant une façade amovible est par exemple décrit dans le FR 2 890 513 A1 (Parrot).

Le boîtier et la façade logent divers circuits électroniques respectifs, et possèdent chacun un élément d'un connecteur permettant de relier ensemble ces circuits lorsque la façade est appliquée contre le boîtier, de manière à rendre l'autoradio fonctionnel. Des moyens mécaniques assurent également dans cette position le verrouillage de la façade sur le boîtier.

Un autre exemple d'autoradio à façade amovible est le modèle *RK 8200* commercialisé par Parrot SA, Paris, France, appareil qui est notamment décrit dans la demande française 07 06347 du 11 septembre 2007 pour *"Appareil audio pour véhicule avec un logement pour appareils électroniques portables",* publiée sous la référence FR 2 920 945 A1 le 13 mars 2009. La façade détachable de cet appareil cache une trappe dans laquelle peut être placé un téléphone portable pouvant être couplé à l'autoradio par une liaison sans fil de type *Bluetooth* (marque déposée du Bluetooth SIG, Inc.), ou bien un baladeur couplé à l'autoradio par une prise enfichable placée au fond de la trappe.

La façade enferme l'essentiel des circuits électroniques de pilotage de l'appareil ainsi que les circuits haute fréquence du tuner FM et l'interface *Bluetooth,* plus divers boutons et touches de commande, un écran de visualisation, un lecteur de carte mémoire, des microphones pour permettre un fonctionnement "mains libres" du téléphone, etc. Le boîtier, quant à lui, comporte les circuits d'alimentation reliés au réseau de bord du véhicule, l'amplificateur de puissance audio et divers éléments de connectique.

Dans cet appareil, la mise en place de la façade se fait en plaquant celle-ci contre la face avant, ouverte, du boîtier, puis en la verrouillant à ce dernier par encliquetage au moyen d'un système à griffes et crochets, pouvant être libéré par appui sur un bouton placé sur le côté de la façade.

La mise en place de la façade sur le boîtier exige cependant un peu de doigté de la part de l'utilisateur, alors même que, selon l'endroit où l'autoradio est placé sur le tableau de bord, les conditions de manipulation ne sont pas toujours idéales. De plus, comme l'appareil comporte une trappe destinée à recevoir un baladeur ou un téléphone portable, les manoeuvres de mise en place et de retrait de la façade sont assez fréquentes, beaucoup plus que pour une simple façade antivol.

En outre, il est important de bien positionner la façade au moment de sa mise en place, afin que les deux éléments homologues du connecteur électrique façade/boîtier puissent être accouplés correctement.

Enfin, un tel système doit être suffisamment robuste pour pouvoir tolérer les fausses manoeuvres et les imprécisions de mise en place.

Pour ménager un accès commode à la trappe intérieure d'un autoradio pouvant loger un téléphone portable, le FR 2 768 975 A1 prévoit une façade pivotante articulée sur le boîtier à la manière d'un volet. À l'une de ses extrémités la façade est pourvue d'une charnière (non démontable) articulée sur le boîtier et, à l'extrémité opposée (distale), d'un verrou destiné à éviter toute ouverture intempestive du volet formé par la façade. Ce verrou peut être mécanique ou bien magnétique, avec des aimants coopérants disposés sur l'extrémité distale de la façade pivotante et sur le boîtier en vis-à-vis.

Ce système présente l'inconvénient de ce que la façade n'est pas amovible, et ne peut donc pas jouer de rôle antivol ; elle ne peut pas non plus, comme dans le cas de l'appareil *RK8200* précité décrit dans la demande FR 2 920 945 A1, être utilisée comme périphérique connectable à un ordinateur, par exemple pour y charger depuis l'ordinateur des morceaux de musique qui seront plus tard lus avec l'autoradio.

En tout état de cause, quand bien même la charnière serait adaptée pour pouvoir être démontable, une fragilité importante subsisterait au niveau de cette charnière. En outre, un problème supplémentaire viendrait s'ajouter, à savoir celui de l'établissement d'une liaison électrique découplable entre le boîtier et la façade : en effet, tant que la façade n'est pas séparable du boîtier, cette liaison peut être simplement réalisée par une nappe de fils, sans connecteur intermédiaire ; en revanche, si l'on veut pouvoir la détacher complètement, il est nécessaire de prévoir des moyens de couplage/découplage des circuits du boîtier avec les circuits de la façade.

Le EP 1 283 132 A2 propose pour cela un couplage sans fil, non galvanique, par exemple un couplage par voie électromagnétique (couplage RF) ou optique (couplage infrarouge). Cette technique présente l'inconvénient d'une plus grande complexité des circuits du boîtier et de la façade du fait des interfaces nécessaires, et en outre celui d'une emprise sur la surface utile dans l'espace central du boîtier, du fait de la nécessaire présence des transducteurs ( boucle RF, etc.).

Ce dernier inconvénient n'est pas gênant si cet espace central est seulement occupé par une fente d'insertion d'un CD, mais l'est beaucoup plus lorsque l'on souhaite, comme dans le cas de l'appareil *RK8200* précité décrit dans la demande FR 2 920 945 A1, utiliser cet espace central pour ménager une trappe d'accès à un logement susceptible d'enfermer dans le boîtier de l'autoradio un téléphone portable ou un baladeur, car la surface occupée par les transducteurs réduit d'autant les dimensions de la trappe.

L'invention vise au contraire un appareil dans lequel le boîtier et la façade sont couplés par voie galvanique au moyen d'un connecteur électrique.

La difficulté consiste alors à assurer un couplage à la fois facile et sûr au moment du montage de la façade sur le boîtier, et d'autre part à pouvoir maintenir ce couplage en toutes circonstances, notamment en dépit des vibrations, chocs, secousses, etc. que l'appareil est susceptible de rencontrer dans un environnement automobile.

Pour pallier cette difficulté, et en outre éviter les inconvénients exposés plus haut, l'invention propose, essentiellement, d'articuler la façade au boîtier à l'une de ses extrémités latérales au moyen d'une "charnière magnétique" réalisée au moyen d'éléments magnétiques respectifs disposés en vis-à-vis sur la façade et sur le boîtier, avec le verrou situé à l'extrémité de la façade opposée à celle portant la charnière magnétique et avec le connecteur disposé à proximité des éléments magnétiques.

Les avantages résultant de cette configuration sont multiples :
- montage facile de la façade sur le boîtier, sans risque de fausse manoeuvre;
- une fois la façade montée, force de maintien maximale (exercée par les éléments magnétiques réunis) au niveau du connecteur, évitant tout risque de coupure intempestive - avec même, en cas de séparation accidentelle, retour automatique à la position de couplage ;
- lors de la séparation de la façade, effort minime à exercer (par effet de bras de levier) pour dissocier les éléments magnétiques et découpler le connecteur ;
- large étendue libérée dans la partie centrale du boîtier, car les éléments mécaniques (charnière et connecteur d'une part, verrou d'autre part) ne sont situés qu'aux régions latérales extrêmes du boîtier.

A ce dernier égard, on notera que l'orientation du connecteur dans le sens vertical, disposition rare dans les configurations traditionnelles, résulte de la disposition axiale verticale de la charnière magnétique, ce qui va dans le sens souhaité de minimisation de l'emprise sur la partie centrale du boîtier.

Plus précisément, la présente invention propose un appareil électronique audio/vidéo du type général décrit dans le EP 1 283 132 A2 précité, c'est-à-dire comportant : un boîtier, notamment un boîtier intégrable dans un tableau de bord de véhicule automobile, logeant un premier ensemble de circuits électroniques ; une façade montée de manière amovible sur le boîtier, cette façade logeant un second ensemble de circuits électroniques reliés à une pluralité d'organes de commande et de contrôle apparents sur la façade ; et des moyens mécaniques, aptes à permettre l'assemblage et la fixation de la façade sur le boîtier.

De façon caractéristique de l'invention, les moyens mécaniques d'assemblage et de fixation de la façade sur le boîtier comprennent : à une première extrémité latérale de la façade et du boîtier, des moyens formant charnière démontable, comportant au moins une paire d'éléments magnétiques respectifs disposés en vis-à-vis sur le boîtier et sur la façade ; et à une seconde extrémité latérale, opposée, des moyens de verrouillage de la façade au boîtier. L'appareil comprend en outre un connecteur électrique, comportant des organes coopérants sur le boîtier et sur la façade, pour relier ensemble lesdits premier et second ensembles de circuits électriques, de manière à rendre l'appareil électronique fonctionnel lorsque la façade est montée sur le boîtier. Le connecteur électrique est disposé à proximité de ladite au moins une paire d'éléments magnétiques des moyens formant charnière démontable.

Selon diverses caractéristiques subsidiaires avantageuses :
- les éléments magnétiques sont des aimants permanents disposés en vis-à-vis sur le boîtier et sur la façade ;
- les moyens formant charnière démontable sont essentiellement dépourvus de pièce de liaison mécanique de la façade au boîtier, le couplage mécanique de la façade et du boîtier à cet endroit ne résultant que de l'attraction mutuelle des éléments magnétiques en vis-à-vis ;
- les moyens formant charnière démontable comportent deux paires d'éléments magnétiques, disposées de part et d'autre du connecteur électrique. Dans ce cas, ces deux paires d'éléments magnétiques peuvent être dimensionnées et disposées de manière à définir entre elles un domaine dans lequel le connecteur électrique est circonscrit en entier, et suivant une direction perpendiculaire à la plus grand dimension de la façade, cette dimension définissant un axe de pivotement des moyens formant charnière démontable ;
- le connecteur électrique comprend une saillie formée sur le boîtier, notamment une saillie périphérique du connecteur électrique, emboîtable dans une forme en creux conjuguée formée sur la façade, ou *vice versa ;*
- les moyens de verrouillage de la façade au boîtier comprennent une fermeture à verrou mécanique et/ou une fermeture magnétique ou électromagnétique ;
- il est en outre prévu à ladite seconde extrémité latérale des moyens de guidage comprenant une saillie formée sur le boîtier, emboîtable dans une forme en creux conjuguée formée sur la façade, ou *vice versa.*

On va maintenant décrire un exemple de mise en oeuvre du dispositif de l'invention, en référence aux dessins annexés où les mêmes références numériques désignent d'une figure à l'autre des éléments identiques ou fonctionnellement semblables.
La Figure 1 est une vue perspective générale d'un appareil selon l'invention, appliquée à la réalisation d'un autoradio avec une façade amovible montée sur un boîtier.
La Figure 2 est une vue perspective montrant la façade et le boîtier en position dissociée, laissant apparaître les divers éléments de couplage électriques et mécaniques respectifs.
La Figure 3 est une vue en élévation, de face, du boîtier de l'autoradio des Figures 1 et 2.
La Figure 4 est une vue en élévation, de dos, de la façade de l'autoradio des Figures 1 et 2.
La Figure 5 est une vue partielle en élévation latérale de l'autoradio, en coupe selon V-V des Figures 3 et 4, dans une configuration où la façade est montée sur le boîtier.

L'autoradio selon l'invention se présente sous la forme d'un ensemble de dimensions normalisées, intégrable dans la planche de bord d'un véhicule automobile, et constitué d'un boîtier 100 et d'une façade amovible 200.

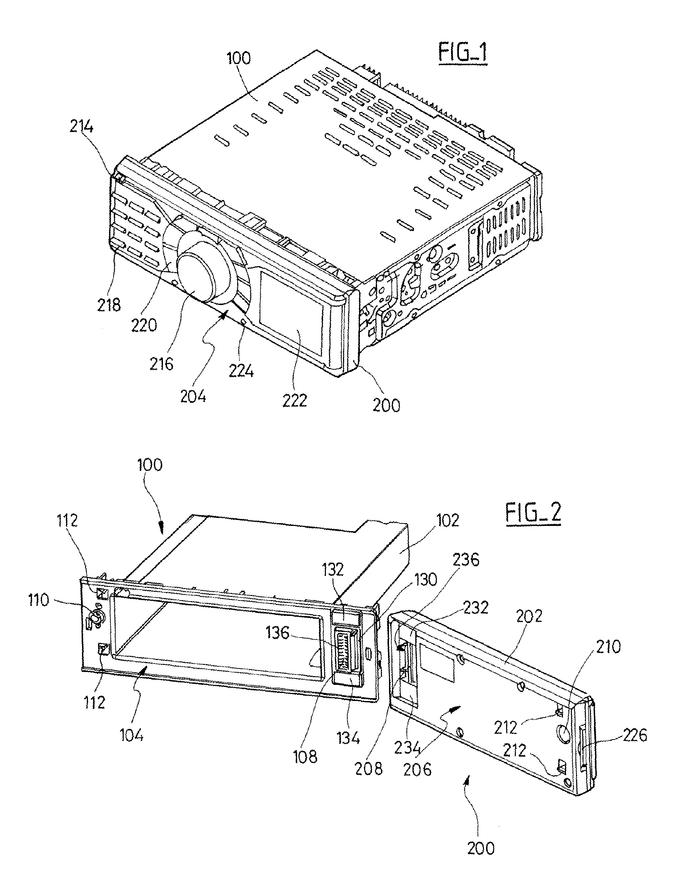

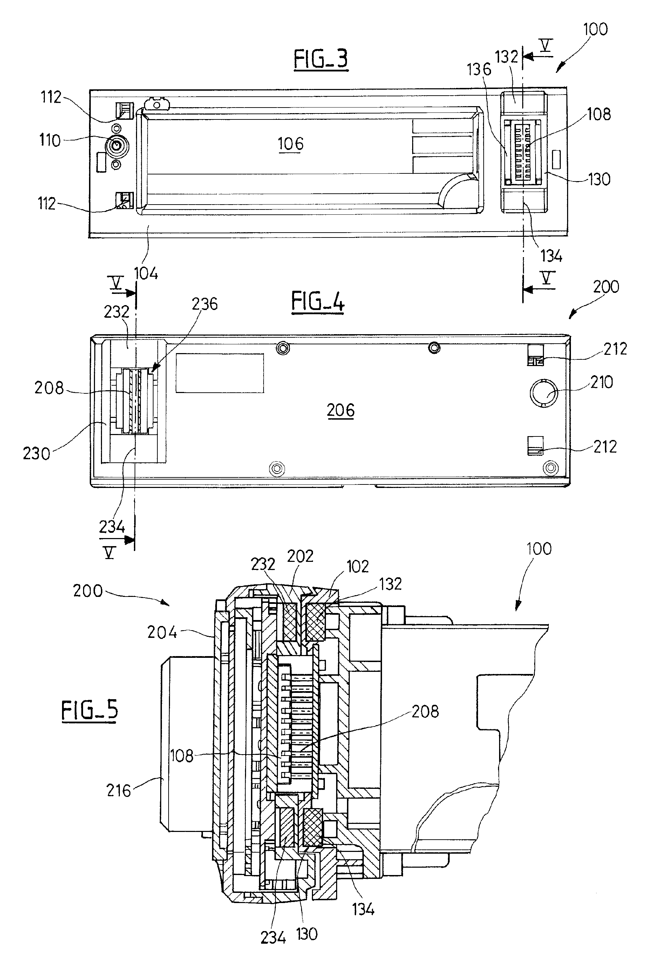

Le boîtier 100 comporte, comme illustré plus précisément Figures 2 et 3, un corps 102 avec une face avant 104 ouverte sur un logement interne ou trappe 106, par exemple destiné à recevoir un téléphone portable ou un baladeur numérique. Le boîtier 100 comprend également, sur la face avant 104, un élément de connecteur 108 situé d'un côté de la trappe 106 (à droite sur la figure), tandis qu'il est prévu sur le côté opposé (à gauche) un relief 110 pour le guidage de la façade au moment de la fermeture ainsi que des moyens de verrouillage, par exemple sous forme de crochets 112.

La façade amovible 200 se présente quant à elle, comme illustré plus précisément Figures 2 et 4, sous la forme d'un élément parallélépipédique aplati 202, avec une face avant 204 tournée vers l'utilisateur et une face arrière 206 destinée à être plaquée contre la face avant 104 du boîtier 100. La face arrière 206 comporte un élément de connecteur 208 homologue de l'élément 108 du boîtier et disposé en vis-à-vis de ce dernier, de manière à permettre leur emboîtement et leur couplage lorsque la façade est plaquée contre le boîtier. La face arrière 206 comporte également un alvéole de guidage 210 homologue du relief 110 du boîtier, ainsi que des moyens de verrouillage 212, par exemple sous forme de crochets encliquetables et verrouillables sur les crochets 112 du boîtier 100 situés en vis-à-vis, ces éléments pouvant être découplés par appui sur un bouton 214 (Figure 1) placé à l'extrémité de la façade. Sur sa face avant, apparente 204, la façade 200 comporte un certain nombre d'organes de commande et de contrôle ou d'entrée/sortie tels que : bouton rotatif 216, clavier 218, touches 220 de contrôle d'un téléphone ou d'un baladeur, écran de visualisation 222, microphones 224, lecteur de carte mémoire 226 (Figure 2).

De façon caractéristique de l'invention, la façade amovible 200 est montée et articulée sur le boîtier au moyen d'un système à "charnière magnétique" mettant en oeuvre des couples d'aimants 132, 232 ou 134, 234 montés respectivement sur la face avant 104 du boîtier 100, et sur la face arrière 206 de la façade 200.

Les aimants utilisés sont d'un type procurant une attraction suffisante même lorsqu'ils sont éloignés de quelques millimètres, par exemple des aimants au néodyme qui procurent une force d'attraction très élevée sous une très faible taille.

Ces aimants sont avantageusement montés à proximité immédiate du connecteur 108, 208, par exemple sur un support 130, 230 entourant le connecteur. Dans la configuration illustrée, il est prévu deux aimants 132, 134 sur le boîtier (et, de la même façon, deux aimants 232, 234 sur la façade), qui sont disposés au-dessus et au-dessous du connecteur 108 (au-dessus et au-dessous du connecteur 208, pour la façade). Cette configuration définit un axe vertical pour la "charnière magnétique", ce qui permet d'articuler la façade mobile sur le boîtier par pivotement autour de cet axe. Les deux couples d'aimants jouent ainsi le rôle de deux points d'articulation pour le boîtier et la façade, sans qu'il soit besoin d'ajouter aucune pièce de liaison mécanique, le couplage mécanique de la façade et du boîtier à cet endroit (côté proximal de la charnière) ne résultant que de l'attraction mutuelle des paires d'aimants en vis-à-vis.

La mise en place de la façade sur le boîtier se fait très simplement en approchant ces deux éléments dans la région du connecteur 108, 208 : l'attraction mutuelle des aimants 132, 232 et 134, 234 va immédiatement assurer le couplage mécanique de la façade au boîtier et, en même temps, établir la connexion électrique du fait de l'emboîtement des deux éléments 108, 208 du connecteur. Cette manoeuvre peut être facilitée si l'on donne aux parties en vis-à-vis du connecteur une forme par exemple en saillie 136 pour le connecteur 108 du boîtier, homologue d'une forme en creux 236 pour le connecteur 208 de la façade : une telle configuration mâle/femelle assure, outre un détrompage, un guidage précis des deux éléments lorsque l'attraction mutuelle des aimants vient rapprocher la façade du boîtier dans la région du connecteur, de sorte que toute fausse manoeuvre ou imprécision de placement sera évitée.

Une fois la "charnière magnétique" ainsi formée, il suffira à l'utilisateur de rabattre l'extrémité opposée de la façade (côté distal de la charnière) contre la face avant 104 du boîtier 100, jusqu'à venir encliqueter les crochets respectifs 112, 212, avec guidage par insertion du relief 110 dans l'alvéole 210. Le couplage à la fois mécanique et électrique de la façade 100 au boîtier 200 est ainsi parfait.

En variante, le système de fermeture purement mécanique à crochets 112, 212 peut être remplacé par un système de verrou magnétique (totalement indépendant des aimants 132, 134, 232, 234 de la fermeture magnétique), ou encore une fermeture par électro-aimant, libérable par une commande électrique.

Dans une autre variante encore, la paire d'aimants homologues peut être remplacée par un aimant simplement associé à un élément ferromagnétique passif, par exemple un plaque en acier doux remplaçant les aimants 232, 234 de la façade.

## Revendications

1. Un appareil électronique audio/vidéo, notamment un autoradio, comportant :
- un boîtier (100), notamment un boîtier intégrable dans un tableau de bord de véhicule automobile, logeant un premier ensemble de circuits électroniques ;
- une façade (200) montée de manière amovible sur le boîtier, cette façade logeant un second ensemble de circuits électroniques reliés à une pluralité d'organes (216-224) de commande et de contrôle apparents sur la façade ; et
- des moyens mécaniques, aptes à permettre l'assemblage et la fixation de la façade sur le boîtier,
**caractérisé en ce que :**
- les moyens mécaniques d'assemblage et de fixation de la façade sur le boîtier comprennent :
• à une première extrémité latérale de la façade et du boîtier, des moyens formant charnière démontable, comportant au moins une paire d'éléments magnétiques respectifs (132, 232 ; 134, 234) disposés en vis-à-vis sur le boîtier et sur la façade ; et
• à une seconde extrémité latérale, opposée, des moyens (112, 212) de verrouillage de la façade au boîtier,
- l'appareil comprend en outre un connecteur électrique (108, 208), comportant des organes coopérants sur le boîtier et sur la façade, pour relier ensemble lesdits premier et second ensembles de circuits électriques, de manière à rendre l'appareil électronique fonctionnel lorsque la façade est montée sur le boîtier, et
- le connecteur électrique (108, 208) est disposé à proximité de ladite au moins une paire d'éléments magnétiques (132, 232 ; 134, 234) des moyens formant charnière démontable.

2. L'appareil de la revendication 1, dans lequel ladite paire d'éléments magnétiques comprend des aimants permanents disposés en vis-à-vis sur le boîtier et sur la façade.

3. L'appareil de la revendication 1, dans lequel les moyens formant charnière démontable sont essentiellement dépourvus de pièce de liaison mécanique de la façade au boîtier, le couplage mécanique de la façade et du boîtier à cet endroit ne résultant que de l'attraction mutuelle des éléments magnétiques en vis-à-vis (132, 232 ; 134, 234).

4. L'appareil de la revendication 1, dans lequel les moyens formant charnière démontable comportent deux paires d'éléments magnétiques (132, 232, 134, 234), disposées de part et d'autre du connecteur électrique (108, 208).

5. L'appareil de la revendication 4, dans lequel les deux paires d'éléments magnétiques (132, 232, 134, 234) sont dimensionnées et disposées de manière à définir entre elles un domaine dans lequel le connecteur électrique (108, 208) est circonscrit en entier.

6. L'appareil de la revendication 4, dans lequel les deux paires d'éléments magnétiques (132, 232, 134, 234) sont disposées de part et d'autre du connecteur électrique suivant une direction perpendiculaire à la plus grand dimension de la façade, cette dimension définissant un axe de pivotement des moyens formant charnière démontable.

7. L'appareil de la revendication 1, dans lequel le connecteur électrique comprend une saillie (136) formée sur le boîtier, emboîtable dans une forme en creux conjuguée (236) formée sur la façade, ou *vice versa.*

8. L'appareil de la revendication 7, dans lequel la saillie (136) est une saillie périphérique du connecteur électrique (108, 208).

9. L'appareil de la revendication 1, dans lequel les moyens de verrouillage de la façade au boîtier comprennent une fermeture à verrou mécanique (112, 212) et/ou une fermeture magnétique ou électromagnétique.

10. L'appareil de la revendication 1, dans lequel il est en outre prévu à ladite seconde extrémité latérale des moyens de guidage comprenant une saillie (110) formée sur le boîtier, emboîtable dans une forme en creux conjuguée (210) formée sur la façade, ou *vice versa.*
